# EUROPÄISCHE PATENTSCHRIFT

(11) **EP 3 242 399 B1**
(45) Veröffentlichungstag und Bekanntmachung des Hinweises auf die Patenterteilung: **10.07.2019**
(21) Anmeldenummer: 17169374.0
(22) Anmeldetag: 04.05.2017
(51) Int. Cl.: H03K 17/082, H03K 17/687, H01L 27/02, H02H 9/02, H02H 3/08, H02H 9/04

(54) **MONOLITHISCH INTEGRIERTER HALBLEITERSCHALTER, INSBESONDERE LEISTUNGSTRENNSCHALTER**
MONOLITHIC INTEGRATED SEMICONDUCTOR, IN PARTICULAR ISOLATING SWITCH
COMMUTATEUR À SEMI-CONDUCTEUR INTÉGRÉ MONOLITHIQUE, EN PARTICULIER COMMUTATEUR DE SÉPARATION DE PUISSANCE

(30) Priorität: 06.05.2016 DE 102016207859
(43) Veröffentlichungstag der Anmeldung: 08.11.2017
(73) Patentinhaber: Fraunhofer-Gesellschaft zur Förderung der angewandten Forschung e.V., 80686 München (DE)
(72) Erfinder: Hürner, Andreas, 90459 Nürnberg (DE); Erlbacher, Tobias, 91099 Poxdorf (DE)
(74) Vertreter: Gagel, Roland

(56) Entgegenhaltungen:
- EP-A2- 1 168 449
- WO-A1-2005/020402
- WO-A2-2008/063674

## Beschreibung

### Technisches Anwendungsgebiet

Die vorliegende Erfindung betrifft einen monolithisch integrierten Halbleiterschalter, insbesondere einen Leistungstrennschalter, mit einem ersten und einem zweiten monolithisch integrierten Feldeffekttransistor, wobei eine Source- oder Emitter-Elektrode des ersten Feldeffekttransistors mit einer Source- oder Emitter-Elektrode des zweiten Feldeffekttransistors kurzgeschlossen ist, eine Drain- oder Kollektor-Elektrode des ersten Feldeffekttransistors mit einem ersten Spannungsanschluss und eine Drain- oder Kollektor-Elektrode des zweiten Feldeffekttransistors mit einem zweiten Spannungsanschluss des Halbleiterschalters verbunden sind.

Halbleiterschalter werden als Leistungstrennschalter beispielsweise zur Begrenzung und Abschaltung eines Überstromes in einem elektrischen Netzwerk genutzt. Bei Auftreten eines Kurzschlusses innerhalb eines elektrischen Netzwerkes wird der Laststrom lediglich von der Impedanz des Netzwerkes begrenzt. Es entsteht ein Überstrom, aus dem eine signifikante thermische Belastung der angeschlossenen Lasten resultiert. Um eine sich hieraus ergebende Beschädigung dieser Lasten zu vermeiden, ist eine schnelle Begrenzung und Abschaltung des Überstromes erforderlich, bei der unter anderem auch die Zündung von Lichtbögen vermieden werden sollte.

### Stand der Technik

In der Energieübertragungstechnik wurde diese Problematik bisher typischerweise durch Verwendung mechanischer Leistungstrennschalter gelöst. Diese Leistungstrennschalter werden zum Ein- und Ausschalten von Betriebsströmen sowie zum Abschalten von Kurzschlussströmen im Fehlerfall eingesetzt. Im Normalbetrieb müssen sie sowohl alle Betriebsströme führen als auch den dabei auftretenden thermischen und dynamischen Beanspruchungen standhalten. Im Kurzschlussfall muss der Leistungstrennschalter den Strompfad möglichst abrupt und sicher abschalten, damit nachfolgende Betriebsmittel nicht geschädigt oder zerstört werden. Die Trennstelle muss dabei eine durchschlagsichere Isolierstrecke zwischen den benachbarten Leitern bilden.

Bei mechanischen Leistungstrennschaltern werden die Schaltstücke im Störfall über einen mechanischen Hebel voneinander getrennt. Dabei wird die Stromdichte im Kontaktbereich so groß, dass sich eine Schmelzbrücke bildet. Der daraus zwischen den Kontakten entstehende Lichtbogen hält den Stromkreis zunächst geschlossen. Im Wechselstrom erlischt der Lichtbogen beim Spannungsnulldurchgang. Damit der Lichtbogen jedoch beim Wiederanstieg der Spannung nicht erneut zündet, muss die Lichtbogenstrecke entionisiert werden. Dies wird durch Kühlung des Lichtbogens mittels eines Löschmittels wie Beispiel SF₆ oder durch Vakuum erzielt. Der Schaltvorgang kann mehrere Zyklen andauern. Während des Abschaltvorganges steigt der Strom rapide an und nähert sich abhängig von der Abschaltdauer der Amplitude des Stoßstromes immer weiter an. Die Größe der Amplitude ist von der Netzstruktur und der darin zur Verfügung stehenden Kurzschlussleistung abhängig. Die Gesamtzeit von der Detektion bis zur vollständigen Trennung des Strompfades kann dabei weit über 100ms andauern. Innerhalb dieser Periode fließt der Überstrom durch die nachfolgenden Betriebsmittel, die aufgrund dessen auch für diesen Überstrom dimensioniert werden müssen. Um die Überstrombelastung zu reduzieren, müsste der Leistungsschalter schneller abschalten. Jedoch verstärkt ein zu schneller Schaltvorgang bei mechanischen Leistungstrennschaltern die Lichtbogenintensität, wodurch zusätzliche Energie zum Löschen benötigt wird und der Verschleiß der Kontakte voranschreitet. Daher ist es schwer, mit mechanischen Schaltern kurze Schaltzeiten zu erreichen.

Eine weitere Möglichkeit zur Lösung der obigen Problematik stellt die Verwendung halbleiterbasierter Leistungstrennschalter dar. Diese Schalter sind in der Lage, in einigen Mikrosekunden abzuschalten. Zudem bilden sie keinen Lichtbogen aus, so dass kein zusätzliches Löschmittel benötigt wird. Aufgrund fehlender beweglicher Teile sind sie verschleiß- und wartungsarm und durch ihren kompakten Aufbau auch platzsparend. Grundsätzlich besteht ein derartiger Leistungstrennschalter aus mehreren parallel oder in Serie geschalteten Einzelbauelementen, insbesondere Thyristoren, GTOs und IGBTs. Da Leistungstrennschalter in dieser Anwendung überwiegend im Ein-Zustand betrieben werden, können Schaltverluste und Sperreigenschaften in erster Näherung unberücksichtigt bleiben. Folglich sind IGBTs aufgrund ihrer signifikant höheren Durchlassverluste im Vergleich zu Thyristoren ungeeignet. Thyristoren scheinen sich aufgrund ihrer geringen Durchlassverluste besser zu eignen und sind für Sperrspannungen bis 8kV erhältlich. Das Zünden erfolgt durch einen geringen Gatestrom oder durch einen Lichtimpuls. Zum Löschen muss ein bestimmter Haltestrom unterschritten werden. Dies erfolgt bei Wechselstrom durch Überschreiten des Nulldurchgangs selbsttätig. Jedoch ist eine gewisse Freiwerdezeit einzuhalten, in welcher die verbleibenden Ladungsträger aus der Raumladungszone ausgeräumt werden. Dies kann bis zu mehreren 100µs dauern. Während dieser Zeit muss der Wiederanstieg der Spannung begrenzt werden, da ansonsten der Thyristor spontan wieder gezündet wird. Die Freiwerdezeit verlängert sich allerdings durch Anstieg des Vorwärtsstromes oder bei steigender Temperatur. Weiterhin ist zu beachten, dass der Thyristor aufgrund des Nulldurchgangs ein kontinuierliches Zündsignal erfordert. Im Gegensatz dazu können Gate-Turn-Off-Thyristoren (GTO) durch einen rückwärtigen Steuerstrom abgeschaltet werden. Dies kann jedoch nicht allein durch den internen Aufbau des Halbleiters erreicht werden, sondern bedarf einer zusätzlichen RCD-Beschaltung, um beim Abschalten den Wiederanstieg der Spannung zu begrenzen. Problematisch bei derartigen Leistungsschaltern ist, dass keine galvanische Trennung in Sperrbetrieb besteht. Selbst im Sperrbetrieb fließen immer noch geringe Sperrströme im mA-Bereich.

Aus M. Callaviket al., "The Hybrid HVDC Breaker. ABB Grid System", Technical Paper Nov. 2012, ist ein hybrider Leistungsschalter für die Gleichstromübertragung bekannt. Dabei handelt es sich um eine Parallelschaltung aus einem Bypass und dem aus Leistungshalbleitern aufgebauten elektrischen Leistungstrennschalter, der den Hauptschalter bildet. Im Normalbetrieb fließt der Strom durch den Bypass. Dieser setzt sich aus einem schnell schaltenden mechanischen Leistungsschalter und einem Kommutator zusammen. Im Störfall bewirkt der Kommutator eine Erhöhung des Leitungswiderstandes, so dass der Strom zum Hauptstrompfad kommutiert. Der Kommutator wird durch in Serie geschaltete IGBTs verwirklicht, welche den Leitungswiderstand mittels Änderung der Gate-spannung erhöhen. Nach einer kurzen Zeitverzögerung öffnet sich der mechanische Schalter. Der Strom wird nun vom Hauptschalter unterbrochen. Der gesamte Abschaltvorgang dauert unter 5ms. Jedoch ist der komplette Aufbau sehr aufwändig und teuer.

Ein grundsätzliches Problem der vorangehend erläuterten Lösungsansätze stellt der komplexe Aufbau der Leistungstrennschalter dar. Dieser bedarf einer umfangreichen Ansteuerelektronik, die letztlich zu einer Einschränkung der Zuverlässigkeit des Gesamtsystems führt.

Aus B. Rosensaft et al., "Circuit Breaker and Safe Controlled Power Switch", Proc. of the 19th International Symposium on Power Semiconductor Devices & ICs, Korea 2007, S. 169-172, ist ein monolithisch integrierter Leistungstrennschalter mit einem n-JFET und einem p-JFET bekannt, der nach Prinzip des so genannten dualen Thyristors aufgebaut ist. Bei dieser Verschaltung sind die Source-Elektroden beider JFETs miteinander, die Gate-Elektrode des p-JFET mit dem Anodenanschluss und die Gate-Elektrode des n-JFET mit dem Kathodenanschluss kurzgeschlossen. Analog zu einem Thyristor, der nach dem Überkopfzünden einen hohen Stromfluss mit niedriger Flussspannung aufrechterhält, kann der duale Thyristor nach dem Auslösen eine hohe Sperrspannung mit minimalem Sperrstrom halten. Während der selbsthaltende Thyristor mittels Nulldurchgang der Spannung gelöscht wird, erfolgt das (Wieder-)Einschalten des dualen Thyristors, auch unter dem Begriff SSCB (Solid State Circuit-Breaker) bekannt, durch einen Nulldurchgang des Stroms. Im Gegensatz zum Thyristor ist beim SSCB anstelle des Überkopfzündens durch eine zu hohe Sperrspannung das Überkopfsperren mittels zu hoher Stromstärke möglich. Damit kann dieses Bauelement als selbstauslösendes rücksetzbares Sicherungselement bei Kurzschlüssen und Überströmen der elektrischen Energieübertragung eingesetzt werden. Im Normalfall fließt der Phasenstrom über den niederohmigen Leistungstrennschalter. Im Fehlerfall schaltet der Leistungstrennschalter innerhalb einiger 100µs in einen hochohmigen Zustand und nimmt dabei die volle Phasenspannung dauerhaft (bis zum Rücksetzen) auf.

Allerdings sind bei einem derartigen Leistungsbauelement die maximale Kathodenspannung von der Sperrfestigkeit der Gate-Elektrode des n-JFET sowie die maximale Anodenspannung von der Sperrfestigkeit der Gate-Elektrode des p-JFET begrenzt. Damit eignet sich ein derartig aufgebauter Leistungsschalter lediglich für kleine Betriebsspannungen, insbesondere bei einer monolithischen Integration. Die Gatepotentiale der JFETs werden dabei ausschließlich über Halbleitergebiete angesteuert, so dass eine Ansteuerung über die Gate-Elektroden von außen nicht möglich ist. Für höhere Betriebsspannungen wurden in der genannten Veröffentlichung von Rosensaft et al. auch Abwandlungen eines derartigen Leistungstrennschalters gezeigt, die im Wesentlichen auf der Prozesstechnologie des MOSbasierten IGBTs mit einem monolithisch integrierten n-Kanal MOSFET basieren.

Die DE 60122626 T2 beschreibt einen Halbleiterschalter mit zwei monolithisch integrierten Feldeffekttransistoren, von denen einer einen n-dotierten und einer einen p-dotierten Kanal aufweist. Die Source-Elektrode des ersten Feldeffekttransistors ist mit der Source-Elektrode des zweiten Feldeffekttransistors kurzgeschlossen. Die Drain-Elektrode des ersten Feldeffekttransistors ist mit einem ersten elektrischen Anschluss und die Drain-Elektrode des zweiten Feldeffekttransistors mit einem zweitem elektrischen Anschluss des Halbleiterschalters elektrisch verbunden. Ein Wannengebiet des zweiten Feldeffekttransistors ist mit den Source-Elektroden beider Feldeffekttransistoren und ein Wannengebiet des ersten Feldeffekttransistors mit dem zweiten elektrischen Anschluss kurzgeschlossen. Die Gate-Elektrode des zweiten Feldeffekttransistors ist mit dem ersten elektrischen Anschluss kurzgeschlossen. Die Gate-Elektrode des ersten Feldeffekttransistors ist mit den Source-Elektroden beider Feldeffekttransistoren kurzgeschlossen und über eine Zenerdiode mit dem ersten elektrischen Anschluss verbunden. Die Zenerdiode sorgt dafür, dass die an dem Halbleiterschalter anliegende Spannung hauptsächlich am zweiten Feldeffekttransistor anliegt, dem die Durchbruchspannung der Zenerdiode zugeordnet ist.

Die Aufgabe der vorliegenden Erfindung besteht darin, einen Halbleiterschalter anzugeben, der sich als Leistungs- oder Lasttrennschalter auch bei hohen Betriebsspannungen einsetzen lässt und eine schnelle automatische Abschaltung bei Überströmen ermöglicht.

### Darstellung der Erfindung

Die Aufgabe wird mit dem monolithisch integrierten Halbleiterschalter gemäß Patentanspruch 1 gelöst. Vorteilhafte Ausgestaltungen des Halbleiterschalters sind Gegenstand der abhängigen Patentansprüche oder lassen sich der nachfolgenden Beschreibung sowie den Ausführungsbeispielen entnehmen.

Der vorgeschlagene monolithisch integrierte Halbleiterschalter ist aus zwei Halbleiterbauelementen aufgebaut, deren Steuerungsprinzip wenigstens für eines der Halbleiterbauelemente dem Steuerungsprinzip eines Sperrschicht-Feldeffekttransistors (JFET) entspricht. Der Halbleiterschalter stellt einen dualen Thyristor dar. Die Source- oder Emitter-Elektrode des ersten Feldeffekttransistors ist dabei mit der Source- oder Emitter-Elektrode des zweiten Feldeffekttransistors kurzgeschlossen. Das Source- oder Emitter-Gebiet des ersten Feldeffekttransistors und das Source- oder Emitter-Gebiet des zweiten Feldeffekttransistors grenzen dabei vorzugsweise aneinander. Die Drain- oder Kollektor-Elektrode des ersten Feldeffekttransistors ist mit einem ersten elektrischen Anschluss des Halbleiterschalters, die Drain- oder Kollektor-Elektrode des zweiten Feldeffekttransistors mit einem zweiten elektrischen Anschluss des Halbleiterschalters verbunden. Die beiden elektrischen Anschlüsse stellen den Anodenanschluss und den Kathodenanschluss dar. In einer ersten Ausgestaltung des vorgeschlagenen Halbleiterschalters sind die Gate- oder BasisElektroden beider Feldeffekttransistoren mit dem ersten elektrischen Anschluss kurzgeschlossen. Das Wannengebiet des zweiten Feldeffekttransistors ist mit den beiden Source- oder Emitter-Elektroden der beiden Feldeffekttransistoren kurzgeschlossen. Das Wannengebiet des ersten Feldeffekttransistors ist mit dem zweiten elektrischen Anschluss kurzgeschlossen. Das Kanalgebiet der Feldeffekttransistoren liegt jeweils zwischen der Gate-Elektrode und dem Wannengebiet. In einer zweiten Alternative des vorgeschlagenen Halbleiterschalters ist lediglich die Gate- oder Basis-Elektrode des ersten Feldeffekttransistors mit dem ersten elektrischen Anschluss kurzgeschlossen. Die Gate- oder Basis-Elektrode des zweiten Feldeffekttransistors ist dann mit einer externen Gate-Ansteuerung verbind- bzw. beschaltbar.

In beiden Ausgestaltungsalternativen ist wenigstens einer der Feldeffekttransistoren ein JFET und der andere entweder ein JFET oder ein BIFET (Bipolarer Feldeffekttransistor). So kann der erste Feldeffekttransistor ein p-JFET und der zweite Feldeffekttransistor ein n-JFET oder n-BIFET sein, wobei dann der erste elektrische Anschluss den Kathodenanschluss und der zweite elektrische Anschluss den Anodenanschluss darstellt. Der erste Feldeffekttransistor kann auch ein n-JFET sein. In diesem Fall wird als zweiter Feldeffekttransistor ein p-JFET oder p-BIFET eingesetzt, wobei der erste elektrische Anschluss dann den Anodenanschluss und der zweite elektrische Anschluss den Kathodenanschluss darstellt.

Durch die monolithische Integration lässt sich der vorgeschlagene Halbleiterschalter, der im Folgenden aufgrund seiner bevorzugten Anwendung als Leistungstrennschalter bezeichnet wird, platzsparend realisieren. Der Stromfluss über diesen Leistungstrennschalter kann bei Überschreiten einer bestimmten Anoden-Spannung oder dem Überschreiten eines bestimmten Anoden-Stromes automatisch abgeschaltet werden. Eine zusätzliche Ansteuer- und Überwachungselektronik ist hierfür nicht erforderlich. Die Grenzwerte für die Anoden-Spannung und den Anoden-Strom lassen sich durch die Dimensionierung der Feldeffekttransistoren festlegen. Bei einer Realisierung mit getrennter bzw. extern ansteuerbarer Gate-Elektrode des zweiten Feldeffekttransistors können die Grenzwerte auch im Betrieb beeinflusst werden. Der vorgeschlagenen Lösung liegt die Erkenntnis zugrunde, dass das n⁺-Gate des kathodenseitigen Feldeffekttransistors vor der Anodenspannung geschützt werden kann, indem nicht die Anodenspannung mit dem n⁺-Gate sondern mit dem Substratkontakt verbunden und das n⁺-Gate auf Kathodenpotential gelegt wird. Damit wird gegenüber dem zuletzt genannten Stand der Technik für die Beherrschbarkeit des Gate-Anoden-Potentials keine Isolationsschicht zwischen dem Gate-Potential und der der darüber geführten Source-Elektrode benötigt. Die Spannung wird vielmehr ausschließlich über pn-Übergänge abgebaut. In diesem Stand der Technik ist die Nutzung der Gate-Elektrode nicht möglich, weil dort die Potentialtrennung zwischen Kathode bzw. Anode zum Gate des jeweils anderen Transistors nicht gegeben wäre.

Mit dem vorgeschlagenen Leistungstrennschalter wird somit die maximale Sperrfestigkeit nicht mehr durch die maximale an die Gate-Elektrode anlegbare Spannung, sondern durch die Dimensionierung des Driftgebietes bestimmt. Durch entsprechende Wahl der Dicke und Dotierung des Driftgebietes lassen sich monolithisch integrierte Leistungstrennschalter mit Sperrfestigkeiten von bis zu 10kV (Silicium) bzw. 200kV (Siliciumkarbid) realisieren.

Durch Verwendung eines p-dotierten Kollektorgebietes in der Ausgestaltung mit einem BIFET statt einem JFET werden im eingeschalteten Zustand zusätzliche Ladungsträger in das Driftgebiet injiziert. Dadurch lassen sich niedrige statische Verluste auch bei sehr hohen Sperrfestigkeiten realisieren.

Durch den Einsatz von Siliciumkarbid ergibt sich zudem die Möglichkeit, Halbleiterbauelemente bzw. einen darauf basierenden Leistungstrennschalter für den Betrieb bei hohen Sperrspannungen zu realisieren, so dass auch Anwendungen in der Mittelspannungsebene (10kV bzw. 20kV) und in der HGÜ-Technik (HGÜ: Hochspannungs-Gleichstrom-Übertragung) für dessen Einsatz in Frage kommen. Während in der Mittelspannungsebene eine Funktionalität bei Wechselspannung (mit Polaritätswechsel) gegeben sein muss, bedarf es bei der HGÜ-Technik nur eines Betriebs bei einer Polarität. Im Gegensatz zu mechanischen Trennschaltern ist vor allem die schnelle Auslösegeschwindigkeit ein erheblicher Vorteil.

Der vorgeschlagene monolithisch integrierte Halbleiter- bzw. Leistungstrennschalter mit regenerativem Abschaltverhalten lässt sich insbesondere zur Sicherung elektrischer Netze und Anlagen einsetzen. Beispiele sind die Sicherung von Gleichspannungsanlagen, zum Beispiel zur Energieübertragung in Gebäuden, zur Energieversorgung von elektrischen Antrieben aus einem Gleichspannungszwischenkreis oder für ähnliche Anwendungen. Dies ist selbstverständlich keine abschließende Aufzählung. Insbesondere lässt sich der vorgeschlagene Halbleiterschalter nicht nur als Leistungstrennschalter sondern auch für andere Schaltanwendungen einsetzen.

### Kurze Beschreibung der Zeichnungen

Der vorgeschlagene monolithisch integrierte Leistungstrennschalter wird nachfolgend anhand von Ausführungsbeispielen in Verbindung mit den Zeichnungen nochmals näher erläutert. Hierbei zeigen:
- Fig. 1: ein erstes Beispiel eines erfindungsgemäßen Leistungstrennschalters im Ersatzschaltbild;
- Fig. 2: ein zweites Beispiel eines erfindungsgemäßen Leistungstrennschalters im Ersatzschaltbild;
- Fig. 3: ein drittes Beispiel eines erfindungsgemäßen Leistungstrennschalters im Ersatzschaltbild;
- Fig. 4: ein viertes Beispiel eines erfindungsgemäßen Leistungstrennschalters im Ersatzschaltbild;
- Fig. 5: ein fünftes Beispiel eines erfindungsgemäßen Leistungstrennschalters im Ersatzschaltbild;
- Fig. 6: einen schematischen Querschnitt eines beispielhaften Aufbaus des erfindungsgemäßen Leistungstrennschalters;
- Fig. 7: ein Beispiel für den Einsatz des erfindungsgemäßen Leistungstrennschalters als Schutzvorrichtung bei Überströmen in einer Netzanwendung; und
- Fig. 8: ein Beispiel für einen Einsatz des erfindungsgemäßen Leistungstrennschalters in einer hybriden Anordnung als Schutzvorrichtung bei Überströmen in einer Netzanwendung.

### Wege zur Ausführung der Erfindung

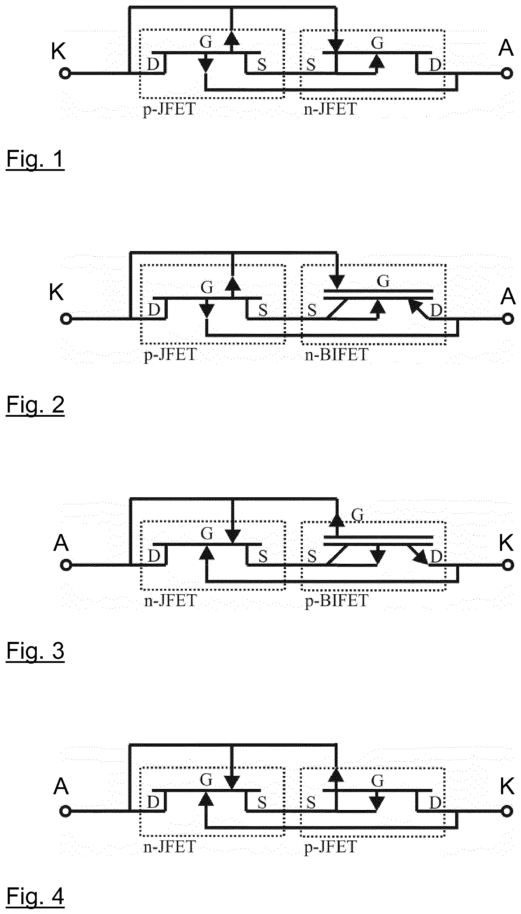

Figur 1 zeigt ein Ersatzschaltbild für ein Beispiel des vorgeschlagenen integrierten Leistungstrennschalters aus zwei JFETs. Der erste JFET verfügt über ein p-dotiertes Kanalgebiet und entspricht damit einem p-JFET. Der zweite JFET verfügt dagegen über ein n-dotiertes Kanalgebiet und entspricht somit einem n-JFET. Die Source-Elektroden S dieser beiden JFETs sowie das Wannengebiet des n-JFET sind kurzgeschlossen. Weiterhin sind die Gate-Elektrode G des n-JFET, die Gate-Elektrode G des p-JFET sowie die Drain-Elektrode D des p-JFET über die Kathode K kurzgeschlossen. Das Wannengebiet des p-JFET ist hingegen mit der Anode A kurzgeschlossen. Somit wird der Betriebszustand des p-JFET durch das Potential an der Anode bestimmt. Der Betriebszustand des n-JFET wird dagegen durch den Potentialunterschied über dem p-dotierten Kanalgebiet zwischen der Drain-Elektrode D und der Source-Elektrode S des p-JFET bestimmt. Im normalen Betriebszustand wird eine positive Spannung an die Anode A und eine negative Spannung an die Kathode K angelegt. In diesem Betriebszustand fließt der Strom aus der Kathode über das p-dotierte Kanalgebiet des p-JFET und das n-dotierte Kanalgebiet des n-JFET zur Anode. In Abhängigkeit der Anodenspannung wird das p-dotierte Kanalgebiet des p-JFET verarmt und der Potentialunterschied zwischen der Source-Elektrode und der Gate-Elektrode des n-JFET nimmt zu. Ab einer bestimmten Anodenspannung resultiert aus diesem Potentialunterschied die Verarmung des n-dotierten Kanalgebietes des n-JFET und der Stromfluss über den monolithisch integrierten Leistungsschalter wird abgeschaltet. Der vorliegenden Erfindung liegt die Erkenntnis zugrunde, dass das n⁺-Gate des kathodenseitigen Transistors vor der Anodenspannung geschützt werden kann, indem nicht die Anodenspannung mit dem n⁺-Gate sondern mit dem Substratkontakt verbunden wird und das n+-Gate auf Kathodenpotential gelegt wird.

In einer weiteren beispielhaften Ausgestaltung des vorgeschlagenen Leistungstrennschalters wird der n-JFET des vorangegangenen Ausführungsbeispiels durch einen n-BIFET ersetzt, wie dies im Ersatzschaltbild der Figur 2 dargestellt ist. Die Verschaltung und Funktionsweise ändern sich dadurch nicht.

Eine weitere Möglichkeit einer Realisierung des vorgeschlagenen Leistungstrennschalters ist im Ersatzschaltbild der Figur 3 dargestellt. In diesem Beispiel ist der p-JFET des Ausführungsbeispiels der Figur 2 durch einen n-JFET und der n-BIFET durch einen p-BIFET ersetzt. Anode und Kathode müssen dazu entsprechend vertauscht werden.

Schließlich zeigt Figur 4 noch eine weitere Variationsmöglichkeit der eingesetzten Feldeffekttransistoren beim vorgeschlagenen Leistungstrennschalter in einem Ersatzschaltbild. Gegenüber dem vorangegangenen Ausführungsbeispiel der Figur ist hier der p-BIFET durch einen p-JFET ersetzt. Die restliche Verschaltung ist bei den vorangegangenen Ausführungsbeispielen jeweils identisch, wie dies aus den Figuren 1 bis 4 erkennbar ist.

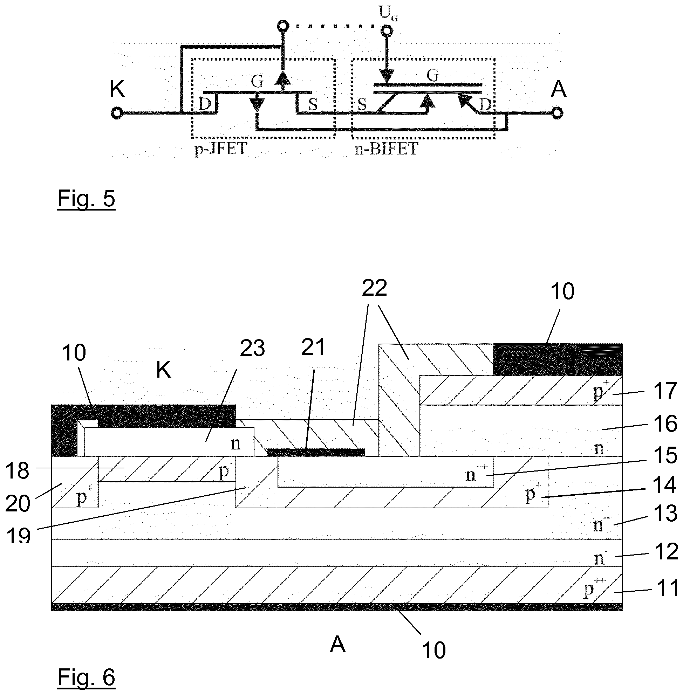

Darüber hinaus lässt sich der vorgeschlagene Leistungstrennschalter auch in einer Verschaltung realisieren, wie sie in Figur 5 beispielhaft im Ersatzschaltbild dargestellt ist. Im Unterschied zur Ausgestaltung der Figur 2 ist hier die Gate-Elektrode G des n-BIFET nicht mit der Gate-Elektrode G des p-JFET und der Kathode K kurzgeschlossen. Vielmehr ermöglicht diese Ausgestaltung die Beschaltung der Gate-Elektrode G des n-BIFET durch eine externe Gate-Ansteuerung. Hierdurch wird es möglich, die Kippspannung und den Kippstrom des Leistungstrennschalters gezielt durch das Anlegen einer Gate-Spannung zu beeinflussen. Eine derartige Beeinflussung ist mit dem Leistungstrennschalter des letztgenannten Standes der Technik nicht möglich, da dort die Gatepotentiale der JFETs ausschließlich über Halbleitergebiete angesteuert werden. Diese in Figur 5 dargestellte Modifikation lässt sich analog auch mit den Ausgestaltungen der Figuren 1, 3 und 4 durchführen.

Figur 6 zeigt ein Beispiel für eine Realisierung des in Figur 5 im Ersatzschaltbild dargestellten Leistungstrennschalters. Dieser Leistungstrennschalter wird durch monolithische Integration eines lateralen p-JFET und eines vertikalen n-BIFET realisiert. Der monolithisch integrierte Leistungstrennschalter besteht demnach aus dem p-dotierten Kollektorgebiet 11, dem n-dotierten Feldstoppgebiet 12, dem n-dotierten Driftgebiet 13, dem p-dotierten Wannengebiet 14, dem n-dotierten Emittergebiet 15 des n-BIFET, dem n-dotierten Kanalgebiet 16 des n-BIFET, dem p-dotierten Gategebiet 17 des n-BIFET, dem p-dotierten Kanalgebiet 18 des lateralen p-JFET sowie den p-dotierten Source- 19 und Draingebieten 20 des lateralen p-JFET, wie dies in der Figur 6 dargestellt ist. Das Emittergebiet 15 und Wannengebiet 14 des n-BIFET sowie das Sourcegebiet 19 des p-JFET sind über eine ohmsche Schicht 21 miteinander verbunden. Diese ohmsche Schicht 21 ist durch eine Isolationsschicht 22 von der Metallisierung 10 der Kathode K isoliert. Die ohmsche Verbindung zwischen der Drain-Elektrode und dem n-dotierten Gategebiet 23 des p-JFET erfolgt über die Metallisierung 10 der Kathode K. Das Driftgebiet 13 stellt weiterhin das Wannengebiet des p-JFET dar.

Durch Substitution des p-dotierten Kollektorgebietes 11 durch ein n-dotiertes Kollektorgebiet ließe sich mit dem gezeigten Aufbau eine monolithische Integration eines n-JFET und eines p-JFET realisieren. Als Halbleitersubstrat wird bevorzugt Silicium oder Siliciumcarbid, besonders bevorzugt der 4H-Polytyp von Siliciumcarbid eingesetzt. Die in Figur 2 dargestellte Schaltung lässt sich mit einem derartigen Aufbau realisieren, indem die Metallisierung über der Drain-Elektrode und dem n-dotierten Gategebiet 23 des p-JFET bis zum p-dotierten Gategebiet 17 des n-BIFET verlängert wird, so dass sie zwischen diesen Gebieten eine ohmsche Verbindung herstellt.

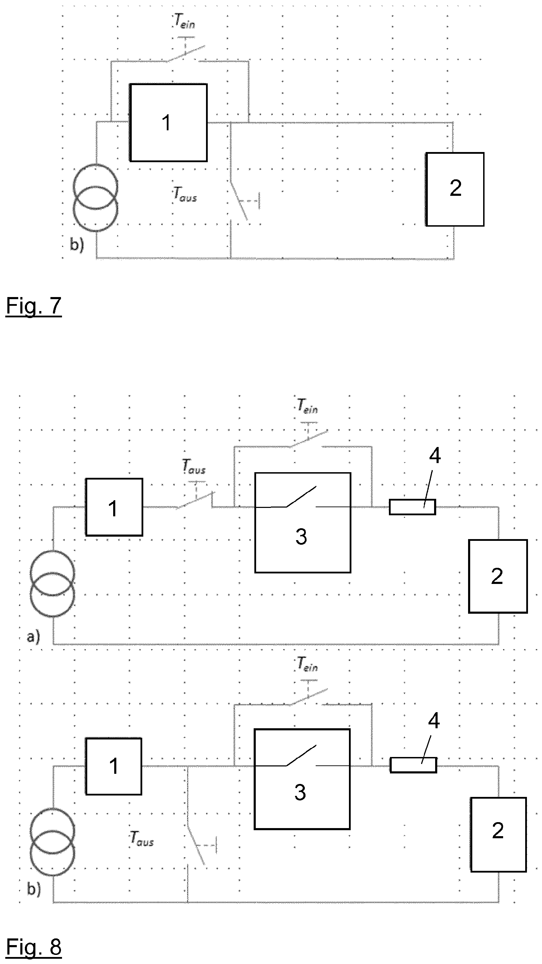

In den Figuren 7 und 8 sind beispielhafte Anwendungen des erfindungsgemäßen Leistungstrennschalters als Schutzschaltung in ein einem Energienetzwerk dargestellt. Die Einbindung ins Netz sowie die Ausführung der Ein-/Aus-Taster entsprechen dabei dem im jeweiligen Netz (Spannungsebene) üblichen Stand der Technik und sind hier nur symbolisch als Taster Tₑᵢₙ/Tₐᵤₛ ausgeführt. Figur 7 zeigt den vorgeschlagenen Leistungstrennschalter 1 als Schutzorgan bei Überströmen (z.B. Lastkurzschluss) in einer Netzwerkanwendung (Gleich- oder Wechselspannung). Die Last 2 ist in dieser Figur ebenfalls schematisch dargestellt.

Die in Figur 8 dargestellte Konfiguration mit dem vorgeschlagenen Leistungstrennschalter 1 trägt der Notwendigkeit eines mechanischen Lasttrennschalters in elektrischen Energieübertragungsstrecken Rechnung. Diese ist gegebenenfalls gesetzlich vorgeschrieben und stellt eine mechanische Trennung von Netz und Last 2 sicher. Figur 8 zeigt hierzu einen hybriden Lasttrennschalter bestehend aus in diesem Beispiel selbst haltendem mechanischen oder magnetischen Schütz 3 mit einem Relais 4 und dem vorgeschlagenen Leistungstrennschalter 1. Die Last 2 ist in dieser Figur ebenfalls wieder schematisch dargestellt. Teilabbildung A zeigt die Situation mit trennendem Aus-Taster Tₐᵤₛ, Teilabbildung B mit schließendem Aus-Taster Tₐᵤₛ.

### Bezugszeichenliste

- 1: Leistungstrennschalter
- 2: Last
- 3: mechanischer/magnetischer Schütz
- 4: Relais
- 10: Metallisierung
- 11: p-dotiertes Kollektorgebiet
- 12: n-dotiertes Feldstoppgebiet
- 13: n-dotiertes Driftgebiet
- 14: p-dotiertes Wannengebiet
- 15: n-dotiertes Emittergebiet
- 16: n-dotiertes Kanalgebiet (BIFET)
- 17: p-dotiertes Gategebiet
- 18: p-dotiertes Kanalgebiet (JFET)
- 19: p-dotiertes Sourcegebiet
- 20: p-dotiertes Draingebiet
- 21: ohmsche Schicht
- 22: Isolationsschicht
- 23: n-dotiertes Gategebiet
- A: Anode
- D: Drain
- G: Gate
- K: Kathode
- S: Source
- Tₑᵢₙ: Taster
- Tₐᵤₛ: Taster

## Patentansprüche

1. Halbleiterschalter mit einem ersten und einem zweiten monolithisch integrierten Feldeffekttransistor, von denen einer ein JFET und der andere entweder ein JFET oder ein Bipolarer Feldeffekttransistor, BiFET, ist und von denen einer einen n-dotierten (16) und einer einen p-dotierten Kanal (18) aufweist, bei dem
- eine Source- oder Emitter-Elektrode (S) des ersten Feldeffekttransistors mit einer Source- oder Emitter-Elektrode (S) des zweiten Feldeffekttransistors kurzgeschlossen ist,
- eine Drain- oder Kollektor-Elektrode (D) des ersten Feldeffekttransistors mit einem ersten elektrischen Anschluss (K, A) und
- eine Drain- oder Kollektor-Elektrode (D) des zweiten Feldeffekttransistors mit einem zweitem elektrischen Anschluss (A, K) des Halbleiterschalters elektrisch verbunden ist, wobei
- ein Wannengebiet (14) des zweiten Feldeffekttransistors mit den Source- oder Emitter-Elektroden (S) beider Feldeffekttransistoren kurzgeschlossen ist,
- ein Wannengebiet (13) des ersten Feldeffekttransistors mit dem zweiten elektrischen Anschluss (A, K) kurzgeschlossen ist, und
- eine Gate- oder Basiselektrode (G) des ersten Feldeffekttransistors mit dem ersten elektrischen Anschluss (K, A) kurzgeschlossen und eine Gate- oder Basiselektrode (G) des zweiten Feldeffekttransistors mit dem ersten elektrischen Anschluss kurzgeschlossen oder extern ansteuerbar angeordnet ist.

2. Halbleiterschalter nach Anspruch 1,
**dadurch gekennzeichnet,**
**dass** ein Source- oder Emitter-Gebiet (19) des ersten Feldeffekttransistors und ein Source- oder Emitter-Gebiet (15) des zweiten Feldeffekttransistors aneinander grenzen.

3. Halbleiterschalter nach Anspruch 1 oder 2,
**dadurch gekennzeichnet,**
**dass** der erste Feldeffekttransistor ein p-JFET, der erste elektrische Anschluss (K, A) ein Kathodenanschluss und der zweite elektrische Anschluss (A, K) ein Anodenanschluss ist.

4. Halbleiterschalter nach Anspruch 3,
**dadurch gekennzeichnet,**
**dass** der zweite Feldeffekttransistor ein n-JFET ist.

5. Halbleiterschalter nach Anspruch 3,
**dadurch gekennzeichnet,**
**dass** der zweite Feldeffekttransistor n-BIFET ist.

6. Halbleiterschalter nach Anspruch 1 oder 2,
**dadurch gekennzeichnet,**
**dass** der erste Feldeffekttransistor n-JFET, der erste elektrische Anschluss (K, A) ein Anodenanschluss und der zweite elektrische Anschluss (A, K) ein Kathodenanschluss ist.

7. Halbleiterschalter nach Anspruch 6,
**dadurch gekennzeichnet,**
**dass** der zweite Feldeffekttransistor ist p-JFET ist.

8. Halbleiterschalter nach Anspruch 6,
**dadurch gekennzeichnet,**
**dass** der zweite Feldeffekttransistor ein p-BIFET ist.

9. Halbleiterschalter nach einem der Ansprüche 1 bis 8, **dadurch gekennzeichnet,**
**dass** die beiden Feldeffekttransistoren in einem Halbleitersubstrat aus Silicium oder Siliciumkarbid monolithisch integriert sind.

10. Halbleiterschalter nach einem der Ansprüche 1 bis 8, **dadurch gekennzeichnet,**
**dass** die beiden Feldeffekttransistoren in einem Halbleitersubstrat aus dem 4H-Polytyp von Siliciumkarbid monolithisch integriert sind.

## Claims

1. A semiconductor switch having a first and a second monolithically integrated field effect transistor, of which one is a JFET and the other is either a JFET or a bipolar field effect transistor, BiFET, and of which one has an n-doped channel (16) and one has a p-doped channel (18), in which
- a source or emitter electrode (S) of the first field effect transistor is short circuited to a source or emitter electrode (S) of the second field effect transistor,
- a drain or collector electrode (D) of the first field effect transistor is connected to a first electrical terminal (K, A) of the semiconductor switch, and
- a drain or collector electrode (D) of the second field effect transistor is connected to a second electrical terminal (A, K) of the semiconductor switch,
wherein
- a well region (14) of the second field effect transistor is short-circuited to the source or emitter electrodes (S) of both field effect transistors,
- a well region (13) of the first field effect transistor is short-circuited to the second electrical terminal (A, K), and
- a gate or base electrode (G) of the first field effect transistor is short-circuited to the first electrical terminal (K, A) and a gate or base electrode (G) of the second field effect transistor is short-circuited to the first electrical terminal or is arranged so as to be externally controllable.

2. The semiconductor switch according to claim 1, **characterised in that** a source or emitter region (19) of the first field effect transistor and a source or emitter region (15) of the second field effect transistor are arranged adjacent to each other.

3. The semiconductor switch according to claim 1 or 2, **characterised in that** the first field effect transistor is a p-JFET, the first electrical terminal (K, A) is a cathode terminal and the second electrical terminal (A, K) is an anode terminal.

4. The semiconductor switch according to claim 3, **characterised in that** the second field effect transistor is a n-JFET.

5. The semiconductor switch according to claim 3, **characterised in that** the second field effect transistor is a n-BIFET.

6. The semiconductor switch according to claim 1 or 2, **characterised in that** the first field effect transistor is a n-JFET, the first electrical terminal (K, A) is an anode terminal and the second electrical terminal (A, K) is a cathode terminal.

7. The semiconductor switch according to claim 6, **characterised in that** the second field effect transistor is a p-JFET.

8. The semiconductor switch according to claim 6, **characterised in that** the second field effect transistor is a p-BIFET.

9. The semiconductor switch according to any of claims 1 to 8, **characterised in that** both field effect transistors are monolithically integrated in a semiconductor substrate made from silicon or silicon carbide.

10. The semiconductor switch according to any of claims 1 to 8, **characterised in that** both field effect transistors are monolithically integrated in a semiconductor substrate made from the 4H polytype of silicon carbide.

## Revendications

1. Commutateur à semi-conducteur pourvu d'un premier et d'un deuxième transistor à effet de champ intégré de façon monolithique, dont l'un est un transistor à effet de champ de type JFET et l'autre est soit un transistor à effet de champ de type JFET ou un transistor bipolaire à effet de champ BiFET, et dont l'un comporte un canal dopé n (16) et l'autre comporte un canal dopé p (18) sur lequel
- une électrode source ou émettrice (S) du premier transistor à effet de champ est court-circuitée avec une électrode source ou émettrice (S) du deuxième transistor à effet de champ,
- une électrode de drain ou de collecteur (D) du premier transistor à effet de champ est électriquement connectée sur une première borne électrique (K, A) et
- une électrode de drain ou de collecteur (D) du deuxième transistor à effet de champ est électriquement connectée sur une deuxième borne électrique (A, K) du commutateur à semi-conducteur,
- un domaine de confinement (14) du deuxième transistor à effet de champ étant court-circuitée avec les électrodes sources ou émettrices (S) des deux transistors à effet de champ,
- un domaine de confinement (13) du premier transistor à effet de champ étant court-circuité avec la deuxième borne électrique (A, K) et
- une électrode de grille ou de base (G) du premier transistor à effet de champ étant placée en court-circuit avec la première borne électrique (K, A) et une électrode de grille ou de base (G) du deuxième transistor à effet de champ étant placée en court-circuit avec la première borne électrique ou en étant activable en externe.

2. Commutateur à semi-conducteur selon la revendication 1, **caractérisé en ce qu'**une région source ou émettrice (19) du premier transistor à effet de champ et une région source ou émettrice (15) du deuxième transistor à effet de champ sont adjacentes.

3. Commutateur à semi-conducteur selon la revendication 1 ou 2, **caractérisé en ce que** le premier transistor à effet de champ est un JFET dopé P, la première borne électrique (K, A) est une borne de cathode et la deuxième borne électrique (A, K) est une borne d'anode.

4. Commutateur à semi-conducteur selon la revendication 3, **caractérisé en ce que** le deuxième transistor à effet de champ est un JFET dopé N.

5. Commutateur à semi-conducteur selon la revendication 3, **caractérisé en ce que** le deuxième transistor à effet de champ est un BIFET dopé n.

6. Commutateur à semi-conducteur selon la revendication 1 ou 2, **caractérisé en ce que** le premier transistor à effet de champ est un JFET dopé N, la première borne électrique (K, A) est une borne d'anode et la deuxième borne électrique (A, K) est une borne de cathode.

7. Commutateur à semi-conducteur selon la revendication 6, **caractérisé en ce que** le deuxième transistor à effet de champ est un JFET doté P.

8. Commutateur à semi-conducteur selon la revendication 6, **caractérisé en ce que** le deuxième transistor à effet de champ est un BIFET doté P.

9. Commutateur à semi-conducteur selon l'une quelconque des revendications 1 à 8, **caractérisé en ce que** les deux transistors à effet de champ sont intégrés de façon monolithique dans un substrat de semi-conducteur en silicium ou en carbure de silicium.

10. Commutateur à semi-conducteur selon l'une quelconque des revendications 1 à 8, **caractérisé en ce que** les deux transistors à effet de champ sont intégrés de façon monolithique dans un substrat de semi-conducteur du polytype 4H de carbure de silicium.
